# EUROPÄISCHE PATENTSCHRIFT

(11) **EP 0 705 865 B1**
(45) Veröffentlichungstag und Bekanntmachung des Hinweises auf die Patenterteilung: **06.11.2002**
(21) Anmeldenummer: 95115059.8
(22) Anmeldetag: 25.09.1995
(51) Int. Cl.: C08G 77/14, C07F 7/18, C07F 7/08, C08F 2/50

(54) **Mit Silikonen kompatible Photoinitiatoren und diese enthaltende lichtempfindliche Gemische**
Photoinitiators compatible with silicones and photosensitive compositions containing the same
Photoinitiateurs compatibles avec des silicones et compositions photosensibles les contenant

(30) Priorität: 04.10.1994 DE 4435487
(43) Veröffentlichungstag der Anmeldung: 10.04.1996
(73) Patentinhaber: AGFA-GEVAERT, 2640 Mortsel (BE)
(72) Erfinder: Niesert, Claus-Peter, Dr., D-65929 Frankfurt (DE); Pawlowski, Georg, Dr., Shinjuku-ku, Tokyo (JP); Gries, Dr. Willi-Kurt, D-65183 Wiesbaden (DE); Przybilla, Klaus-Jürgen, Dr., D-60322 Frankfurt (DE)

(56) Entgegenhaltungen:
- EP-A- 0 108 037
- EP-A- 0 129 443
- EP-A- 0 162 572
- EP-A- 0 269 573
- EP-A- 0 598 545
- GB-A- 2 078 242
- US-A- 4 391 963
- US-A- 4 467 082
- DATABASE WPI Week 7831, Derwent Publications Ltd., London, GB; AN 78-55676 & JP-A-53 071 199 (SHINETSU CHEM IND KK) 24. Juni 1978

## Beschreibung

Die Erfindung betrifft als Photoinitiatoren geeignete Verbindungen und lichtempfindliche Gemische, die diese Verbindungen enthalten, insbesondere Gemische auf Basis von Silikonharzen und den sich daraus ableitenden Silikonkautschuken.

Für viele Anwendungen hat die photoinduzierte Polymerisation dünner Schichten eine große praktische Bedeutung, beispielsweise bei der Herstellung schnellhärtender Lacküberzüge, der Papierbeschichtung, der Trocknung von Druckfarben oder der Herstellung von Druckplatten. Um eine ausreichende Lichtempfindlichkeit zu erreichen, enthalten die lichtempfindlichen Mischungen in der Regel Photoinitiatoren. Oftmals schränkt jedoch die geringe Löslichkeit der Photoinitiatoren im photoempfindlichen Gemisch deren Anwendungsbreite und Verarbeitbarkeit ein.

Besonders deutlich werden diese Löslichkeitsprobleme bei der Herstellung von lichtempfindlichen Gemischen auf Basis von Silikonen als Bindemittel oder lichtempfindliche Polymere, wie sie in verschiedenen Anwendungsfeldern eingesetzt werden (siehe z.B. U.Müller et al., Plaste u. Kautschuk 34 (1987) 183 oder H.-J.Timpe et al., Adhäsion 1985 (10) 28). Organische Verbindungen wie Photoinitiatoren neigen zur Entmischung aus Gemischen mit Silikon (vgl. z.B. U.Müller, H.-J.Timpe, Kautschuk, Gummi, Kunststoffe, 41 (1988)1131). Deutlich beobachtbar ist die Phasentrennung von Photoinitiator und Silikon zum Beispiel bei der Herstellung dünner Silikonschichten, die Photoinitiatoren enthalten und in zwei Stufen zunächst thermisch, dann photochemisch vernetzt werden können. Nach oder sogar schon während der thermischen Härtung schwitzt oftmals der Photoinitiator aus der Silikonschicht aus oder kristallisiert darin aus. Um dies zu verhindern, ist es wünschenswert, die Kompatibilität von Photoinitiatoren mit Silikonen zu erhöhen.

Solche Materialien auf Silikonbasis, die in zwei Stufen härtbar sind, können unter anderem Verwendung finden in Druckplatten, die für den wasserlosen Offsetdruck geeignet sind. So beschreibt z.B. die DE-A 22 07 495 lichtvernetzbare Silikonschichten als farbabstoßende Schichten für den wasserlosen Offsetdruck. Die DE-A 28 02 085 und DE-A 30 12 953 beschreiben entsprechende Druckplatten, die durch mechanische Trennung von Bild- und Nichtbildstellen nach dem peel-apart-Verfahren entwickelt werden. Dabei wird die farbabstoßende und gleichzeitig lichtempfindliche Schicht von photopolymerisierbaren Silikonen gebildet.

Um die Verträglichkeit mit Silikonen zu erhöhen, ist die Substitution von Photoinitiatoren mit Silyl- bzw. Siloxanylresten, die selbst keine reaktive Gruppe mehr tragen, beschrieben worden (z.B. in der US-A 5,086,192 und der EP-A 162 572). Andererseits sind aus der EP-B 281 941 Photoinitiatoren bekannt, die reaktive Gruppen tragen und über diese kovalent mit verschiedenen Polymeren verknüpft werden können. Geeignete Substituenten, die in den Prozeß der thermischen Härtung von Silikonen eingehen, sind aus der Silikonchemie bekannt, z.B. Trialkoxysilyl- oder Triacetoxysilyl-Reste, die an der Kondensationsvernetzung von Silikonharzen teilnehmen (siehe z.B. W.Noll, Chemie und Technologie der Silicone, Verlag Chemie, Weinheim 1968; G.Körner, M.Schulze, J.Weis (Hrsg.), Silicone, Chemie und Technologie, Vulkan-Verlag, Essen 1989). Beiden Ansätzen gemeinsam ist jedoch, daß speziell substituierte Photoinitiatoren in aufwendigen, meist mehrstufigen Reaktionen synthetisiert werden müssen.

Aufgabe der Erfindung war es daher, Photoinitiatoren bzw. Photosensibilisatoren bereitzustellen, die unter dem Einfluß von Licht eine radikalische Polymerisation auszulösen vermögen, die mit Silikonen verträglich sind und die sich in einem einzigen Reaktionsschritt aus bekannten hochwirksamen Photoinitiatoren bzw. Photosensibilisatoren herstellen lassen.

Erfindungsgemäß werden Verbindungen der allgemeinen Formel I

(SIL - X-)ₘIN (I),

worin
- SIL: einen Rest der Formel Si(R¹)(R²)(R³),
wobei
R¹ ein Alkyl-, Halogenalkyl- oder Alkoxyrest mit 1 bis 8 Kohlenstoffatomen, ein Alkenylrest, ein Alkenyloxyoder Acyloxyrest mit 2 bis 8 Kohlenstoffatomen, ein Aryl- oder Aryloxyrest mit 6 bis 10 Kohlenstoffatomen, ein Dialkyl-, Diaryl- oder Alkylaryl-methylenaminooxyrest mit C₁-C₄-Alkyl- oder C₆-Arylgruppen ist und
R² und R³ gleiche oder verschiedene Reste der Bedeutung von R¹ oder X - IN sind,
- X: eine Gruppe CₙH₂ₙ,
- IN: den Rest einer als Photoinitiator bzw. Photosensibilisator wirksamen Verbindung mit mindestens einer an einem aromatischen Kern stehenden Carbonylgruppe,
- m: eine Zahl von 1 bis 4, und
- n: eine Zahl von 2 bis 12 bedeutet,
oder Verbindungen der allgemeinen Formel II

Siₒ0ₒ₋₁ (-X-IN)ₚR⁴₂ₒ₊₂₋ₚ (II)

worin
- R⁴: ein Rest der Bedeutung von R¹ ist und mehrere R⁴ untereinander gleich oder verschieden sein können,
- o: eine Zahl von 2 bis 20000 und
- p: eine Zahl von 1 bis o
ist, und die Symbole X und IN die vorstehend angegebene Bedeutung haben, wobei die Gruppe X an ein zur Carbonylgruppe von IN orthoständiges aromatisches Kohlenstoffatom gebunden ist.

Erfindungsgemäß wird auch ein Verfahren zur Herstellung der vorstehend definierten Verbindungen vorgeschlagen, das darin besteht, daß man eine Verbindung der Formel III

IN - H, (III)

in der das Wasserstoffatom an einem aromatischen Kohlenstoffatom in einer ortho-Position zu einer Carbonylgruppe steht, in Gegenwart einer katalytischen Menge einer Rutheniumverbindung mit einer Verbindung der Formel IV

SIL - X' (IV)

oder eine Verbindung der Formel IVA

SiₒOₒ₋₁ (-X')ₚR⁴ ₂ₒ₊₂₋ₚ (IVA)

umsetzt, wobei X', ein ω-Alkenylrest mit 2 bis 12 Kohlenstoffatomen ist und IN, SIL, R⁴, o und p die vorstehend angegebene Bedeutung haben.

Erfindungsgemäß wird ferner ein lichtempfindliches Gemisch vorgeschlagen, das
a) ein Polysiloxan,
b) eine radikalisch polymerisierbare Verbindung mit mindestens einer endständigen ethylenisch ungesättigten Gruppe und
c) eine bei Bestrahlung mit aktinischem Licht Radikale bildende Verbindung,
enthält und bei dem die Radikale bildende Verbindung (c) eine Verbindung gemäß einer der vorstehend definierten allgemeinen Formeln I und II ist.

Strukturelle Voraussetzung für die bei der Herstellung der erfindungsgemäßen Verbindungen eingesetzten Photoinitiatoren IN - H ist das Vorhandensein eines Arylketon-Strukturelements im Molekül. Orthoständig zur Carbonylgruppe muß zumindest eine aromatische C-H-Gruppe vorhanden sein. Es sind verschiedene Klassen von Photoinitiatoren bzw. Sensibilisatoren bekannt, die diese Voraussetzungen erfüllen, z.B. Benzoinether und andere Benzoinderivate, Benzilketale, Hydroxyalkylphenone, α-Aminoacetophenonderivate, α-Halogenacetophenonderivate, Benzophenone, Thioxanthone, Anthrachinone oder Acridone.

Seit kurzem ist bekannt, daß bestimmte aromatische Ketone unter dem Einfluß von Ruthenium-Komplexen mit Olefinen derart umgesetzt werden können, daß die zur Carbonylgruppe orthoständige Position am aromatischen Kern durch das Olefin alkyliert wird (S.Murai et al., Nature 366 (1993) 529). Geeignete Olefinkomponenten sind z.B. Vinylsilane. Als Ketonkomponenten werden dort lediglich solche Verbindungen beschrieben, für die eine Wirkung als Photoinitiatoren nicht bekannt ist.

Es zeigte sich, daß diese Umsetzung überraschenderweise auch durchführbar ist, wenn unterschiedliche Substituenten entweder im aromatischen oder im aliphatischen Teil der Ketone vorhanden sind, so daß auch komplizierte Verbindungen, wie die vorstehend genannten Photoinitiatoren, umgesetzt werden können.

Überraschenderweise bleibt die Lichtempfindlichkeit der Photoinitiatoren trotz der Einführung des Silylalkyl-Substituenten weitgehend erhalten. Die Produkte der Umsetzungen besitzen eine erhöhte Verträglichkeit mit Silikonen oder können in die Vernetzung von Silikonen eingreifen. Die auf diesem Weg herstellbaren Silikonkautschuke sind lichtempfindlich.

Die erfindungsgemäßen Photoinitiatoren sind vorzugsweise Verbindungen, in denen IN ein Rest einer der Formeln V und VI. 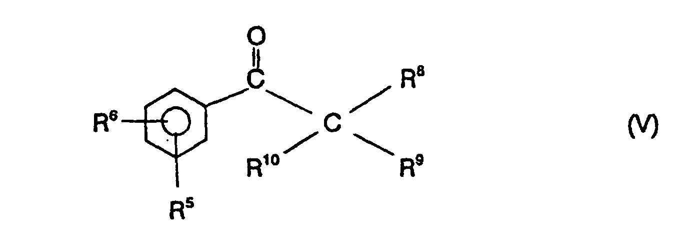 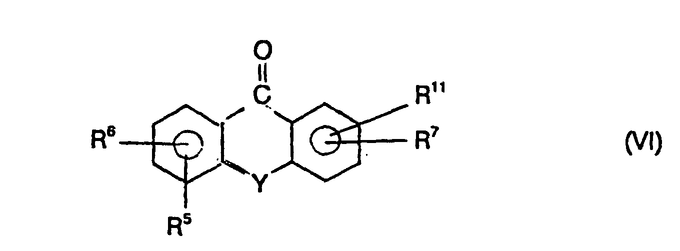 ist,
worin
- R⁵, R⁶ u. R⁷: gleich oder verschieden sind und Wasserstoff-, Halogen-atome, Phenyl-, Benzyl-, Benzoylreste, Alkylreste mit 1 bis 12 Kohlenstoffatomen, Cycloalkylreste mit 5 bis 6 Kohlenstoffatomen oder Reste der Formeln OR¹², SR¹², SOR¹⁵, SO₂R¹⁵, N(R¹³)(R¹⁴), NH-SO₂-R¹⁵ oder NHCOR¹⁵ bedeuten,
- R⁸ und R⁹: gleich oder verschieden sind und Wasserstoffatome, Alkylreste mit 1 bis 12 Kohlenstoffatomen, Alkenylreste mit 2 bis 12 Kohlenstoffatomen, 5- oder 6-gliedrige Cycloalkylreste, Aralkylreste mit 7 bis 9 Kohlenstoffatomen, OR¹², CH₂OR¹² oder N(R¹³)(R¹⁴) bedeuten oder gemeinsam mit dem Kohlenstoffatom, an das sie gebunden sind, einen cycloaliphatischen Ring mit 5 bis 6 Gliedern bilden,
- R¹⁰: ein Wasserstoffatom, OR¹² oder einen Arylrest mit 6 bis 8 Kohlenstoffatomen bedeutet,
wobei
R⁸, R⁹ und R¹⁰ gemeinsam mit dem Kohlenstoffatom, an das sie gebunden sind, einen ggf. substituierten Benzolring bedeuten können und wobei diese Reste einzeln nicht gleichzeitig Wasserstoffatome oder Methylgruppen bedeuten,
- R¹¹: X - SIL oder R⁷ bedeutet und im Falle X - SIL in der 1-Stellung des Dreiringsystems der Formel VI steht,
- R¹²: ein Wasserstoffatom, einen Alkylrest mit 1 bis 12 Kohlenstoffatomen, einen 5- oder 6-gliedrigen Cycloalkylrest oder einen Alkanoylrest mit 2 bis 13 Kohlenstoffatomen bedeutet,
- R¹³ und R¹⁴: gleich oder verschieden sind und Wasserstoffatome, Alkylreste mit 1 bis 12 Kohlenstoffatomen oder 5- oder 6-gliedrige Cycloalkylreste bedeuten oder gemeinsam mit dem Stickstoffatom, an das sie gebunden sind, einen 5- oder 6-gliedrigen heterocyclischen Ring bilden, der als weiteres Heteroatom O, S oder N enthalten kann,
- R¹⁵: einen Alkylrest mit 1 bis 12 Kohlenstoffatomen oder einen Arylrest mit 6 bis 10 Kohlenstoffatomen und
- Y: O, S, NR¹², CH₂, C(O) oder eine Einfachbindung bedeutet, wobei im Falle Y = C(O) auch in der 4- und 5-Stellung des Dreiringsystems Reste X - SIL stehen können.

Wenn R⁸, R⁹ und R¹⁰ einen Benzolring bedeuten, kann dieser z.B. durch Halogenatome, Alkoxygruppen mit 1 bis 8 Kohlenstoffatomen oder Reste R¹⁵ substituiert sein.

Die Reste R¹ und R² sind bevorzugt Alkyl- oder Alkoxygruppen mit 1 bis 4, insbesondere 1 oder 2 Kohlenstoffatomen.

Das Verhältnis p : o liegt im allgemeinen zwischen 1 : 100 und 1 : 2, bevorzugt im Bereich von 1 : 10 bis 2 : 5.

R⁴ ist bevorzugt eine Alkylgruppe mit 1 bis 4 Kohlenstoffatomen, besonders bevorzugt eine Methylgruppe.

X ist eine geradkettige oder verzweigte, ggf. substituierte Alkylengruppe mit bevorzugt 2 bis 6, insbesondere 2 bis 4 Kohlenstoffatomen.

Wenn IN ein Rest der Formel V ist, ist bevorzugt mindestens einer der Reste R⁵ und R⁶ ein Wasserstoffatom. Der andere ist bevorzugt H, Alkyl-, Alkoxy- oder Alkylmercapto mit 1 bis 4, insbesondere 1 oder 2 Kohlenstoffatomen, N(R¹³)(R¹⁴) mit Alkylresten R¹³ und R¹⁴ von jeweils 1 bis 4 Kohlenstoffatomen oder ein zum heterocyclischen Ring mit 5 oder 6 Gliedern geschlossener Rest N(R¹³)(R¹⁴), worin bevorzugt O, S oder NH als weitere Heteroatome enthalten sind.

Wenn die Reste R⁸ und R⁹ getrennt vorliegen, ist bevorzugt mindestens einer von ihnen eine Alkyl- oder Alkoxygruppe mit 1 bis 4 Kohlenstoffatomen und höchstens einer ein Wasserstoffatom, eine Hydroxy- oder Aralkylgruppe, insbesondere eine Benzylgruppe. Der Rest R¹⁰ ist bevorzugt ein ggf. substituierter Phenylrest, eine Hydroxygruppe oder eine tertiäre, ggf. cyclische Aminogruppe. Bevorzugt sind auch Verbindungen, in denen R⁸ und R⁹ zu einem cycloaliphatischen Ring verbunden sind oder in denen R⁸, R⁹ und R¹⁰ gemeinsam einen Benzolring bedeuten.

In der Formel VI bedeuten R⁵, R⁶ und R⁷ bevorzugt Wasserstoffatome. Einer oder zwei dieser Reste können vorzugsweise Halogenatome, Alkylgruppen mit 1 bis 4 Kohlenstoffatomen oder tertiäre Aminogruppen mit 2 bis 6 Kohlenstoffatomen, insbesondere Dialkylaminogruppen mit 1 oder 2 Kohlenstoffatomen in der Alkylgruppe sein.

Y ist bevorzugt O, S, NH oder CO, insbesondere S.

Wenn R¹², R¹³, R¹⁴ und R¹⁵ Alkylreste sind, haben diese bevorzugt 1 bis 6, insbesondere 1 bis 3 Kohlenstoffatome. Als Alkanoylreste werden solche mit 2 bis 4 Kohlenstoffatomen bevorzugt.

Als Alkylreste bzw. Alkylgruppen enthaltende Reste sollen im Rahmen dieser Beschreibung geradkettige oder verzweigte, ggf. durch Halogenatome oder Hydroxygruppen substituierte Reste verstanden werden, deren Kette durch Ethersauerstoffatome unterbrochen sein kann.

Die erfindungsgemäßen Verbindungen werden aus bekannten Ausgangsketonen IN - H hergestellt, die selbst als Photoinitiatoren bzw. -sensibilisatoren wirksam sind. Als Ausgangsverbindungen sind z.B. Benzoinderivate, wie Benzoin, Benzoinmethylether, Benzoinethylether, Benzoinisopropylether, Benzoinacetat; Benzilderivate wie Benzil-dimethylketal; α-Aminoalkyl-phenylketone, wie sie z.B. in der EP-A 287 561 oder 88 050 beschrieben sind; Hydroxyalkyl-phenylketone, z.B. die in der DE-C 27 22 264 oder EP-B 3002 beschriebenen geeignet. Weiterhin sind Thioxanthonderivate wie Thioxanthon, 2-lsopropylthioxanthon, 3-Methylthioxanthon, 2-Chlorthioxanthon, 2,4-Dichlorthioxanthon, 1,7-Dichlor-4-methylthioxanthon; Anthrachinonderivate wie Anthrachinon, 2-Methylanthrachinon, 2-Ethylanthrachinon, 1-Chloranthrachinon, 1,8-Dichloranthrachinon; oder Acridone wie 9(10H)-Acridon, 10-Methyl-9(10H)-acridon, 2-Dimethylamino-9(10H)-acridon, 10-Butyl-2-chlor-9(10H)-acridon )-acridon geeignet.

Die Herstellung der Verbindungen der Formeln I und II erfolgt durch Umsetzung der aromatischen Ketone IN - H (III) mit Verbindungen des Typs SIL - X' (IV), worin SIL die oben angegebene Bedeutung hat, d.h. ein Rest Si(R¹R²R³) oder eine Polymerkette der Formel II ist.

Die Reaktion erfolgt unter Einwirkung geeigneter Katalysatoren, insbesondere Rutheniumverbindungen, wie sie von Murai et al. [Nature 366 (1993) 529] beschrieben sind. Als besonders geeignet hat sich dabei RuH₂(CO)(PPh₃)₃ erwiesen. Die Komponenten werden im allgemeinen in einem inerten Lösemittel wie Toluol, Benzol, Xylol, Chlorbenzol oder aliphatischen, ggf. halogenierten Kohlenwasserstoffen gemischt und bevorzugt unter Schutzgas bei erhöhter Temperatur zur Reaktion gebracht. Die Reaktionstemperatur liegt dabei zwischen 50 und 250°C, bevorzugt zwischen 100°C und 180°C, zweckmäßig bei der Rückflußtemperatur des verwendeten Lösemittels. Besonders bevorzugt ist die Verwendung von Toluol unter Rückflußtemperatur. Eine Verfolgung der Reaktion ist gaschromatographisch oder mittels Dünnschichtchromatographie möglich. Die Produkte können mit den üblichen Methoden, besonders destillativ oder durch Chromatographie, aufgearbeitet und gereinigt werden.

Beispiele für erfindungsgemäße Photoinitiatoren sind die folgenden:
2-[2-(Trimethoxysilyl)-ethyl]benzoinmethylether **(1)**
2-[2-(Trimethoxysilyl)-ethyl)benzoinethylether **(2)**
2-[2-(Trimethoxysilyl)-ethyl]benzoinisopropylether **(3)**
2-[2-(Triethoxysllyl)-ethyl]benzoinisopropylether **(4)**
2-(2-(Trimethoxysilyl)-ethyl]benzildimethylketal **(5)**
1-Hydroxy-1-[2-(2-trimethoxysilyl-ethyl)benzoyl]cyclohexan **(6)**
2-Methyl-1-[4-methylthio-2-(2-trimethoxysilyl-ethyl)phenyl]-2-morphoiino-1-propanon **(7)**
2-Methyl-1-[4-methylthio-2-(2-triethoxysilyl-ethyl)phenyl]-2-morpholino-1-propanon **(8)**
2-Benzyl-2-dimethylamino-1-[2-(2-trimethoxysilyl-ethyl)-4-morpholino-phenyl]-1-butanon **(9)**
2-Benzyl-2-dimethylamino-1-[2-(2-triethoxysilyl-ethyl)-4-morpholino-phenyl]-1-butanon **(10)**
2-Benzyl-2-dimethylamino-1-[2-(2-trimethoxysilyl-propyl)-4-morpholino-phenyl]-1-butanon **(11)**
1-(2-Trimethoxysliyl-ethyl)-thioxanthon **(12)**
1,8-Bis-(2-trimethoxysilyl-ethyl)-thioxanthon **(13)**
2-lsopropyl-8-(2-trimethoxysilyl-ethyl)-thioxanthon **(14)**
2-Isopropyl-1,8-Bis-(2-trimethoxysilyl-ethyl)-thioxanthon **(15)**
2-Benzyl-2-dimethylamino-1-[2-(2-(methyl-bis(trimethylsilyloxy)-silyl)-ethyl)-4-morpholino-phenyl]-1-butanon **(16)**
Siloxan-Copolymeres aus Dimethylsiloxan-, Methyl-vinyl-siloxan- und {2-[2-(2-Benzyl-2-dimethylamino-butanoyl)-5-morpholino-phenyl]ethyl}-methylsiloxan-Einheiten **(17)**
2-[2-(2-Benzyl-2-dimethylamino-butanoyl)-5-morpholino-phenyl]ethyl-terminiertes Polydimethylsiloxan **(18)**

Erfindungsgemäß werden die Photoinitiatoren bzw. Photosensibilisatoren der Formel **I** und **II** in lichtempfindlichen Mischungen verwendet, die meist aus einer Vielzahl von Komponenten bestehen. Durch die Substitution mit Silylalkylresten weisen die erfindungsgemäßen Verbindungen gegenüber den Ausgangsverbindungen insbesondere eine erhöhte Löslichkeit in Silikonmischungen auf oder sind über eine reaktive Silylalkylgruppe in der Lage, in die Härtung von Silikonen (Kondensations- oder Additionsvernetzung) einzugehen. In letzterem Fall werden die Initiatoren bei der Bildung eines Silikonkautschuks kovalent im Silikon-Netzwerk verankert, wodurch die Möglichkeit zum Ausschwitzen und die Diffusion des Initiators im Gemisch verringert bzw. ganz verhindert wird. Im Falle der durch nicht-reaktive Silylalkylreste substituierten Verbindungen wird die Löslichkeit im bzw. die Verträglichkeit mit Polysiloxan erhöht, was die Gefahr der Phasentrennung zwischen InitiatorInitiator/Sensibilisator und Polysiloxan verringert oder beseitigt. Gleichzeitig wird die Diffusionsneigung durch große Silyl- oder Oligo-Polysiloxanreste vermindert. Eine bevorzugte Anwendung der erfindungsgemäßen Verbindungen ist daher ihr Zusatz zu lichtempfindlichen Silikongemischen.

Solche lichtempfindlichen Silikonmischungen enthalten neben mindestens einem der erfindungsgemäßen Photoinitiatoren bzw. Photosensibilisatoren in der Regel reaktionsfähige Silikone, die radikalisch polymerisiert oder vernetzt werden können. Entsprechende reaktive Substituenten sind z.B. Acrylat- oder Methacrylatreste, Vinylsilangruppen in Verbindung mit Mercaptogruppen enthaltenden Siloxanen und Maleinimid- oder Vinylethergruppen enthaltende Polysiloxane. Meist sind diese Reste über Alkylengruppen an das Polysiloxangerüst geknüpft. Gegebenenfalls können den Silikonmischungen auch radikalisch polymerisierbare Verbindungen zugegeben werden, die nicht auf Silikonbasis beruhen. Daneben können den Polysiloxan-Mischungen eine Reihe weiterer Komponenten zugesetzt werden. Dazu zählen Silikon-Vernetzer wie Alkoxy-, Acetoxy- oder Dialkylmethylen-aminooxysilan-Derivate, wie z.B. Dimethyldiethorysilan, N-(2-Aminoethyl)-3-aminopropyl-trimethoxysilan, 3-Methacryloyloxy-propyltrimethoxysilan, (3-Glycidoxy-propyl)trimethoxysilan, Bis-(N-methyl-benzylamido)-ethoxymethylsilan, Vinyltrimethoxysilan, Vinyltriacetoxysilan, Methyl-tris(methylethylmethylen-aminooxy)-silan für kondensationsvernetzbare Gemische oder durch Vinylgruppen oder Wasserstoffatome substituierte Siloxane für additionsvernetzbare Gemische. Die Mischungen können ferner Vernetzungskatalysatoren, wie Zinn-, Zink- oder Platin-Verbindungen oder weitere Photokatalysatoren, Inhibitoren, Wärmestabilisatoren, Lichtstabilisatoren oder Photosensibilisatoren, die ggf. auch silylsubstituiert sein können, enthalten. Farb- oder Füllstoffe, wie Calciumcarbonat, Titandioxid oder Siliciumdioxid, können ebenso enthalten sein wie Lösemittel oder weitere Zusätze.

Der besondere Vorteil solcher Gemische liegt in der Möglichkeit, die Härtung in 2 Stufen durchzuführen. Zunächst kann die Mischung des Silikonharzes durch die bei Silikonen üblichen Reaktionen wie Kondensation oder Addition zu einem vernetzten Silikonkautschuk umgewandelt werden, der die erfindungsgemäßen Photoinitiatoren in gelöster Form (bei Verwendung nicht-reaktiver Silylalkyl-Substituenten) oder kovalent gebunden (bei Verwendung reaktiver Silylalkyl-Substituenten) enthält. Ein solcher Silikonkautschuk weist gegenüber einem Silikonkautschuk in Kombination mit üblichem Photoinitiator eine erhöhte Lagerstabilität auf. Enthält der Silikonkautschuk neben den Photoinitiatoren Verbindungen, die durch eine radikalische Reaktion polymerisiert werden können, so kann durch eine ggf. bildmäßige Belichtung in einem zweiten, nun lichtinduzierten Polymerisationsschritt eine weitere Härtung der Schicht herbeigeführt werden. Durch die Polymerisationsreaktion können aber auch die Kohäsionskräfte innerhalb der Schicht und, bei Verwendung eines geeigneten Schichtaufbaus, die Adhäsionskräfte zu Nachbarschichten gezielt verändert werden.

Die Möglichkeit der Härtung von Silikonen in 2 Schritten, einem thermischen und einem nachfolgenden photochemischen, macht solche Silikonmischungen besonders interessant für die Verwendung in Druckplatten, insbesondere für den wasserlosen Offsetdruck, die sich durch Auseinanderziehen von Träger und Deckfolie ("peel-apart"Technik) und Trennung von Bild- und Nichtbildstellen der Aufzeichnungsschicht entwickeln lassen. Eine Druckplatte für den wasserlosen Offsetdruck weist farbabstoßende Bereiche, die in der Regel aus Silikonmaterialien oder fluorierten Polymeren bestehen, und farbannehmende Bereiche, z.B. aus organischen Polymeren oder der freigelegten Trägeroberfläche, auf. In einem typischen Beispiel besteht eine durch peel-apart-Technik entwickelbare Druckplatte für den wasserlosen Offsetdruck aus einem Trägermaterial, z.B. einer Aluminiumplatte, einer Metallplatte oder einer Kunststoffolie, auf dem sich eine photopolymerisierbare Schicht befindet. Auf dieser Schicht liegt eine lichtempfindliche Silikonschicht, die aus einem vernetzten Silikonkautschuk besteht. Darauf wiederum befindet sich eine Schutz- und Abziehfolie, die an der Silikonschicht eine gewisse Haftung besitzt. Geeignete Haft- und Hilfsschichten können den Schichtaufbau ergänzen. Durch Belichtung wird die lichtempfindliche Silikonschicht und die darunter liegende photopolymerisierbare Schicht bildmäßig gehärtet, wobei die Kohäsionskräfte innerhalb der Silikonschicht zunehmen, aber auch die Haftung an der Photopolymerschicht vergrößert wird. Dies hat zur Folge, daß beim Abziehen der Folie (peel-apart-Entwicklung) die Silikonschicht im belichteten Bereich von der Folie getrennt wird und auf dem Träger verbleibt, während die Silikonschicht im unbelichteten Bereich mit der Abziehfolie entfernt wird. Im belichteten Bereich stößt die Druckplatte nun Druckfarbe ab, während die im unbelichteten Bereich freigelegte photopolymerisierbare Schicht die Druckfarbe annimmt. Druckplatten dieser Gattung sind z.B. in der EP-A 530 674 und der DE-A 27 25 762 beschrieben.

Neben der Verwendung in Silikonmischungen können die erfindungsgemäßen Verbindungen auch in anderen lichtempfindlichen Gemischen eingesetzt werden. In der Regel enthalten solche lichtempfindlichen Mischungen neben den erfindungsgemäßen Initiatoren ein polymeres Bindemittel, oftmals als Hauptkomponente. Da bei der Photolyse des verwendeten Initiators Radikale entstehen, werden der Mischung in aller Regel radikalisch polymerisierbare, ethylenisch ungesättigte Verbindungen zugesetzt, um eine photoinduzierte Erhöhung des Molekulargewichts oder eine Vernetzung zu erreichen. Solche Verbindungen sind vorzugsweise Acryl- oder Methacrylsäure und ihre Derivate, z.B. Pentaerythrittriacrylat, Ethylenglykoldiacrylat oder Polyethylenglykoldimethacrylat, Maleinsäureanhydrid, Maleinsäureamide, Styrolverbindungen, Vinylether oder Vinylester. Den lichtempfindlichen Mischungen können weitere Photoinitiatoren, Photosensibilisatoren, Antioxidantien wie organische Amine, Phosphine oder Allylverbindungen sowie Radikalkettenüberträger wie beispielsweise Thiole, Thiophenole oder Peroxide zugegeben werden. Weiterhin können Farbstoffe, Uchthofschutzmittel, Füllstoffe wie Kieselsäure, Calciumcarbonat oder Gips, Weichmacher wie Glykolderivate oder Alkylphthalate sowie oberflächenaktive Stoffe zugegeben werden. Neben Lösemitteln können zudem weitere, hier nicht genannte Hilfsmittel zusetzt werden.

Besondere Vorteile ergeben sich durch die Möglichkeit, erfindungsgemäße Verbindungen, die reaktive Silylreste enthalten, an andere Verbindungen mit entsprechender Reaktivität, insbesondere Polymere, kovalent anzuknüpfen. Dabei werden der Photoinitiator und ggf. auch die Spaltprodukte der Photolyse ortsfest fixiert.

Photoinitiatoren mit reaktiven Silylalkylgruppen, z.B. Alkoxysilyl-ethyl-Gruppen, können kovalent an entsprechend reaktionsfähige Oberflächen, insbesondere an oxidische Oberflächen (Glas, oxidische Metalloberflächen) geknüpft werden. So können hohe lokale Initiator-Konzentrationen erreicht werden, indem die Oberflächen mit den hier beschriebenen Verbindungen belegt werden. Dies ist besonders vorteilhaft, wenn durch eine Photopolymerisationsreaktion eine hohe Haftung eines Photopolymeren an einer solchermaßen vorbehandelten Oberfläche erreicht werden soll oder Polymere auf die Oberfläche aufgepropft werden sollen.

Der Anteil der erfindungsgemäßen Photoinitiatoren oder -sensibilisatoren an den lichtempfindlichen Mischungen beträgt in der Regel 0,1 - 30, bevorzugt 0,2 - 15 %. Der Rest besteht ganz oder zum überwiegenden Teil aus Polysiloxan. Die Belichtung der Mischungen wird in dem für die jeweiligen Verbindungsklassen typischen Wellenlängenbereich durchgeführt. Typischerweise verwendet man Licht der Wellenlängen 200-600 nm, bevorzugt 250-500 nm.

Die nachstehenden Beispiele sollen die Erfindung erläutern. Nähere Einzelheiten zur Herstellung der beschriebenen Verbindungen können den Synthesebeispielen 1 bis 16 entnommen werden. In den Beispielen 17 bis 20 ist die Anwendung der substituierten Photoinitiatoren in lichtempfindlichen Gemischen, insbesondere auf der Basis von lichtempfindlichen Silikonkautschuken, beschrieben.

Die Synthese von RuH₂(CO)(PPh₃)₃ ist nach bekannten Methoden, ausgehend von käuflichem RuCl₃.aq, durchgeführt worden (J.J.Levison, S.D.Robinson, J.Chem.Soc. (A) 1970, 2947-54). Der Katalysator kann ohne Beeinträchtigung seiner Wirkung roh (ohne chromatographische Reinigung) eingesetzt werden. Die Umsetzungen von Olefinen mit Arylketon-Photoinitiatoren unter RuH₂(CO)-(PPh₃)₃- Katalyse wurden unter Schutzgas (Argon oder N₂) und Uchtausschluß durchgeführt. Probenahme erfolgte durch ein Septum, die Reaktionen wurden über Dünnschichtchromatographie verfolgt (Kieselgel, Heptan/Essigester-Mischungen).

Bei den Daten zur Kernresonanz in den folgenden Beispielen bedeuten:
s = Singulett; s(br) = Singulett (breit), m = Multiplett; mc = zentriertes Multiplett; t = Triplett; d = Dublett; dd = Dublett vom Dublett; q = Quadruplett; hept = Septett; hex = Sextett; J = Kopplungskonstante; H¹, H² ... = H am Kohlenstoffatom 1,2...

### Beispiel 1

### Herstellung von 2-[2-(Trimethoxysilyl)-ethyl]-benzoinmethylether (1)

4,52 g (20 mmol) Benzoinmethylether, 3,36 ml (22 mmol) Vinyltrimethoxysilan, 367 mg (0,4 mmol) RuH₂(CO)(PPh₃)₃ und 30 ml wasserfreies Toluol wurden gemischt und 8 Stunden am Rückfluß gerührt. Dann wurden weitere 2 ml (13 mmol) Vinyltrimethoxysilan zugegeben, es wurde noch 2 Stunden am Rückfluß gerührt, und das Gemisch über Nacht stehengelassen. Nach Zugabe von weiteren 400 mg (0,4 mmol) RuH₂(CO)(PPh₃)₃ wurde nochmals 9 Stunden am Rückfluß gerührt, dann eingeengt und chromatographisch aufgearbeitet (Kieselgel, CH₂Cl₂ bzw. CH₂Cl₂/Ethylacetat). Es wurden 490 mg gelbliches Öl erhalten. ¹H-NMR (CDCl₃): 0,76 ppm (2H, mc, Et-H² [CH₂ am Si]); 2,60 ppm (2H, mc, Et-H¹ [CH₂ am Benzolkern]); 3,45 ppm (3H, s, OCH₃); 3,54 ppm (9H, s, Si(OCH₃)₃); 5,40 ppm (1H, s, Benzoin-H); 7,16-7,72 ppm (8H, m, Ph-H); 7,50 ppm (1H, mc, Ph-H⁶).

### Beispiel 2

### Herstellung von 2-[2-(Trimethoxysilyl)-ethyl]-benzoinethylether (2)

12,01 g (50 mmol) Benzoinethylether, 8,4 ml (55 mmol) Vinyltrimethoxysilan, 918 mg (1 mmol) RuH₂(CO)(PPh₃)₃ und 80 ml wasserfreies Toluol wurden gemischt und 2 Stunden am Rückfluß gerührt. Dann wurden weitere 330 mg (0,4 mmol) RuH₂(CO)(PPh₃)₃ zugegeben und das Gemisch wurde noch einmal 5 Stunden am Rückfluß gerührt, eingeengt und chromatographisch aufgearbeitet (Kieselgel, CH₂Cl₂ bzw. CH₂Cl₂/Ethylacetat, Ethylacetat). Es wurden 10,8 g braunes Öl erhalten, das nach Kugelrohrdestillation (190°C, 0,03 mbar) 9,7 g (50%) gelbliches Öl ergab, ¹H-NMR (CDCl₃): 0,58-0,95 ppm (2H, mc, Et-H²); 1,28 ppm (3H, t, OEt-CH₃); 2,61 ppm (2H, mc, Et-H¹); 3,53 ppm (9H, s, Si(OCH₃)₃); 3,60 ppm (2H, mc, OEt-CH₂); 5,50 ppm (1H, s, Benzoin-H); 7,15-7,37 ppm (8H, m, Ph-H); 7,51 ppm (1H, dd, Ph-H⁶).

### Beispiel 3

### Herstellung von 2-[2-(Trimethoxysilyl)-ethyl]-benzoinisopropylether (3)

10,17 g (40 mmol) Benzoinisopropylether, 6,7 ml (44 mmol) Vinyltrimethoxysilan, 335 mg (0,4 mmol) RuH₂(CO)(PPh₃)₃ und 75 ml wasserfreies Toluol wurden gemischt und 2 Stunden am Rückfluß gerührt. Im Abstand von jeweils 2 Stunden wurden noch 3 x 200 mg (0,2 mmol) RuH₂(CO)(PPh₃)₃ zugegeben. Es wurde über Nacht stehengelassen, nochmals 200 mg (0,2 mmol) RuH₂(CO)(PPh₃)₃ und 1 ml (6,6 mmol) Vinyltrimethoxysilan zugegeben, 8 Stunden am Rückfluß gerührt, eingeengt und chromatographisch aufgearbeitet (Florisil bzw. Kieselgel, CH_{z}Cl₂/Ethylacetat/Heptan-Gemische). Es wurden 10,6 g Öl erhalten, das nach Kugelrohrdestillation (220°C, 0,08 mbar) 9,0 g (56%) gelbliches Öl ergab, ¹H-NMR (CDCl₃): 0,61-0,96 ppm (2H, mc, Et-H²); 1,21 ppm (6H, d, Isopropyl-CH₃, ³J_{H,H}=6,2 Hz); 2,61 ppm (2H, mc, Et-H¹); 3,53 ppm (9H, s, Si(OCH₃)₃); 3,71 ppm (1H, hept, sek. Isopropyl-H); 5,55 ppm (1H, s, Benzoin-H); 7,14-7,39 ppm (8H, m, Ph-H); 7,51 ppm (1H, dd, Ph-H⁶).

### Beispiel 4

### Herstellung von 2-(2-(Triethoxysilyl)-ethyl]-benzoinisopropylether (4)

10,2 g (40 mmol) Benzoinisopropylether, 9,2 ml (44 mmol) Vinyltriethoxysilan und 735 mg (0,8 mmol) RuH₂(CO)(PPh₃)₃ wurden in 60 ml wasserfreiem Toluol gelöst und 1/2 Stunde durch Einleiten von Argon entgast. Dann wurde 7 Stunden unter Uchtausschluß und Argon am Rückfluß gerührt, nach Stehen über Nacht bei Raumtemperatur wurden nochmals 370 mg (0,4 mmol) RuH₂(CO)(PPh₃)₃ und 1 ml (5 mmol) Vinyltriethoxysilan zugegeben und weitere 6,5 Stunden am Rückfluß erwärmt. Nach dem Abdestillieren des Toluols wurde an Kieselgel chromatographiert (zunächst Heptan/CH₂Cl₂ 9:1, dann CH₂Cl₂, dann CH₂Cl₂/Ethylacetat. schließlich Ethylacetat) und durch Kugelrohrdestillation gereinigt. Es wurden 9,8 g (55 %) leicht gelbliches Öl erhalten, ¹H-NMR (CDCl₃): 0,61-0,95 ppm (2H, mc, Et-H²); 1,21 ppm (6H, d, Isopropyl-CH₃, ³J_{H,H}=6,0 Hz); 1,22 ppm (9H, t, Ethoxy-CH₃, ³J_{H,H}=7,0 Hz); 2,61 ppm (2H, mc, Et-H¹); 3,71 ppm (1H, hept, Isopropyl-H); 3,79 ppm (6H, q, Ethoxy-CH₂); 5,55 ppm (1H, s, Benzoin-H); 7,13-7,38 ppm (8H, m, Ph-H); 7,48 ppm (1H, dd, Ph-H⁶, ³J_{H⁵,H⁶}=7,6 Hz).

### Beispiel 5

### Herstellung von 2-[2-(Trimethoxysilyl)-ethyl]-benzildimethylketal (5)

5,12 g (20 mmol) Benzildimethylketal, 3,36 ml (22 mmol) Vinyltrimethoxysilan und 367 mg (0,4 mmol) RuH₂(CO)(PPh₃)₃ wurden in 30 ml wasserfreiem Toluol gelöst und 3 Stunden am Rückfluß gerührt. Nach Zugabe von weiteren 190 mg (0,2 mmol) RuH₂(CO)(PPh₃)₃ wurde eingeengt und chromatographiert (Kieselgel, CH₂Cl₂/Ethylacetat-Gemische). Es wurden 1,6 g bräunliches Öl erhalten, das nach Kugelrohrdestillation 1,4 g (17 %) leicht gelbliches Produkt ergab, ¹H-NMR (CDCl₃): 0,92 ppm (2H, mc, Et-H²); 2,50 ppm (2H, mc, Et-H¹); 3,29 ppm (6H, s, OCH₃); 3,53 ppm (9H, s, Si(OCH₃)₃); 7,09 ppm (1H, mc) + 7,20 ppm (1H, dd) + 7,27-7,36 ppm (4H, m) + 7,49-7,54 ppm (2H, m, Ph-H) sowie 7,60 ppm (1H, dd, Ph-H⁶).

### Beispiel 6

### Herstellung von 1-Hydroxy-1-[2-(2-trimethoxysilyl)-ethyl)-benzoyl]cyclohexan (6)

14,4 g (70 mmol) 1-Hydroxy-1-benzoyl-cyclohexan, 11,75 ml (77 mmol) Vinyltrimethoxysilan und 1,28 g (1,4 mmol) RuH₂(CO)(PPh₃)₃ wurden in 100 ml wasserfreiem Toluol 4,5 Stunden am Rückfluß gerührt. Nach Einengen und Chromatographie (Kieselgel, CH₂Cl₂/Ethylacetat) wurden 12,2 g (49 %) ¹H-NMR-spektroskopisch reines gelbliches Öl erhalten, das durch Kugelrohrdestillation (200°C, 0,2 mbar) weiter gereinigt wurde; ¹H-NMR (CDCl₃): 1,01 ppm (2H, mc, Et-H²); 1,15-1,28 ppm (1H, m, Cyclohexyl-H); 1,57-1,89 ppm (9H, m, Cyclohexyl-H); 2,59 ppm (2H, mc, Et-H¹); 3,33 ppm (1H, s, OH); 3,55 ppm (9H, s, Si(OCH₃)₃); 7,17-7,40 ppm (4H, m, Ph-H).

### Beispiel 7

### Herstellung von 2-Methyl-1-[4-methylthio-2-(2-trimethoxysilyl-ethyl)-phenyl]-2-morpholino-1-propanon (7)

11,18 g (40 mmol) 2-Methyl-1-(4-methylthio-phenyl)-2-morpholino-1-propanon, 735 mg (0,8 mmol) RuH₂(CO)(PPh₃)₃ und 7,3 ml (48 mmol) Vinyltrimethoxysilan wurden in 60 ml wasserfreiem Toluol 1/2 Stunde mit Argon entgast und 5 Stunden am Rückfluß gekocht. Nach Stehen über Nacht wurde nochmals 4 Stunden gekocht, dann wurden 360 mg (0,4 mmol) RuH₂(CO)(PPh₃)₃ und 2 ml (13 mmol) Vinyltrimethoxysilan zugegeben und weitere 5 Stunden am Rückfluß gerührt. Nach Einengen und Chromatographie (Kieselgel, CH₂Cl₂/Ethylacetat) wurden 3,04 g (18 %) gelbliches Öl erhalten, ¹H-NMR (CDCl₃): 1,01 ppm (2H, mc, Et-H²); 1,22 ppm (6H, s, Pr-H³, CH₃); 2,50 ppm (3H, s, -SCH₃); 2,58 ppm (4H, mc, *Morpholin-O-CH₂); 2,69 ppm (2H, mc, Et-H¹); 3,59 ppm (9H, s, Si(OCH₃)₃); 3,70 ppm (4H, mc, **Morpholin-N-CH₂); 7,03 ppm (1H, dd, Ph-H⁵, ³J_{H⁵,H⁶} = 8,4 Hz, ⁴J_{H³,H⁵} = 2,0 Hz); 7,11 ppm (1H, d, Ph-H³); 8,47 ppm (1H, d, Ph-H⁶).
*Protonen am Morpholin - C-3 und -C-5
** Protonen am Morpholin - C-2 und -C-6

### Beispiel 8

### Herstellung von 2-Methyl-1-(4-methylthio-2-(2-triethoxysilyl-ethyl)-phenyl]-2-morpholino-1-propanon (8)

11,18 g (40 mmol) 2-Methyl-1-(4-methylthio-phenyl)-2-morpholino-1-propanon, 735 mg (0,8 mmol) RuH₂(CO)(PPh₃)₃ und 10,0 ml (48 mmol) Vinyltriethoxysilan wurden in 60 ml wasserfreiem Toluol 1/2 Stunde mit Argon entgast und 50 Stunden am Rückfluß gekocht. Nach Einengen und Chromatographie (Kieselgel, CH₂Cl₂/Ethylacetat) wurden 1,02 g (6 %) gelbliches Öl erhalten, 1H-NMR (CDCl₃): 0,99 ppm (2H, mc, Et-H²); 1,22 ppm (6H, s, CH₃); 1,24 ppm (9H, t, CH₃ aus Si(OEt)₃); 2,50 ppm (3H, s, SCH₃); 2,59 ppm (4H, mc, Morpholin-N-CH₂); 2,69 ppm (2H, mc, Et-H¹); 3,70 ppm (4H, mc, Morpholin-O-CH₂); 3,85 ppm (6H, q, SiOCH₂, ³J_{H,H}=6,8 Hz); 7,03 ppm (1H, dd, Ph-H⁵, ³J_{H⁵,H⁶}=8,2 Hz, ⁴J_{H³,H⁵}=2,0 Hz); 7,13 ppm (1H, d, Ph-H³); 8,40 ppm (1H, d, Ph-H⁶).

### Beispiel 9

### Herstellung von 2-Benzyl-2-dimethylamino-1-[2-(2-trimethoxysiiyl-ethyl)-4-morpholino-phenyl]-1-butanon (9)

14,6 g (40 mmol) 2-Benzyl-2-dimethylamino-1-(4-morpholino-phenyl)-1-butanon, 750 mg (0,8 mmol) RuH₂(CO)(PPh₃)₃ und 13,4 ml (88 mmol) Vinyltrimethoxysilan wurden in 50 ml Toluol gelöst und mit N₂ entgast. Nach 41 Stunden Erhitzen unter Rühren am Rückfluß wurde das Lösemittel abdestilliert und das Produkt chromatographiert (Kieselgel, CH₂Cl₂/Ethylacetat). Es wurden 13,8 g (67 %) dunkelrotes Öl erhalten, das durch Kochen in Heptan mit Aktivkohle und anschließende Filtration zu einem gelben, zähen Öl gereinigt werden konnte, ¹H-NMR (CDCl₃): 0,61 ppm (3H, t, Bu-H⁴, ³J_{H,H}=7,2 Hz); 1,12 ppm (2H, mc, Et-H²); 1,88 ppm (2H, mc, Bu-H³); 2,37 ppm (6H, s, N(CH₃)₂); 2,71 ppm (2H, mc, Et-H¹); 3,16 ppm (2H, mc, CH₂-Ph); 3,25 ppm (4H, mc, Morpholin-N-CH₂); 3,63 ppm (9H, s, Si(OCH₃)₃); 3,85 ppm (4H, mc, Morpholin-O-CH₂); 6,61 ppm (1H, dd, Ph-H⁵, ³J_{H⁵,H⁶}=8,6 Hz, ⁴J_{H³,H⁵}=2,6 Hz); 6,75 ppm (1H, d, Ph-H³); 7,14-7,29 ppm (5H, m, Ph'-H); 8,44 ppm (1H, d, Ph-H⁶).

### Beispiel 10

### Herstellung von 2-Benzyl-2-dimethylamino-1-[2-(2-triethoxysilyl-ethyl)-4-morpholino-phenyl]-1-butanon (10)

14,6 g (40 mmol) 2-Benzyl-2-dimethylamino-1-(4-morpholino-phenyl)-1-butanon 750 mg (0,8 mmol) RuH₂(CO)(PPh₃)₃ und 18,4 ml (88 mmol) Vinyltriethoxysilan wurden in 50 ml Toluol gelöst und mit Argon entgast. Nach 29 Stunden Erhitzen unter Rühren am Rückfluß wurde das Lösemittel abdestilliert und chromatographiert (Kieselgel, Heptan/CH₂Cl₂/Ethylacetat). Es wurden 22 g (100%) braunes Öl erhalten, das durch Kochen in Heptan mit Aktivkohle und anschließende Filtration zu einem gelben, zähen Öl gereinigt werden konnte und 20,6 g (95%) ergab, ¹H-NMR (CDCl₃): 0,64 ppm (3H, t, Bu-H⁴, ³J_{H,H}=7,0 Hz); 1,10 ppm (2H, mc, Et-H²); 1,26 ppm (9H, t, CH₃ aus Si(OEt)₃, ³J_{H,H}=6,8 Hz); 1,88 ppm (2H, mc, Bu-H³); 2,36 ppm (6H, s, N(CH₃)₂); 2,72 ppm (2H, mc, Et-H¹); 3,15 ppm (2H, mc, CH₂-Ph); 3,24 ppm (4H, mc, Morpholin-N-CH₂); 3,85 ppm (4H, mc, Morpholin-O-CH₂); 3,88 ppm (6H, q, SiOCH₂); 6,60 ppm (1H, dd, Ph-H⁵, ³J_{H⁵,H⁶} = 8,6 Hz, ⁴J_{H³,H⁵}=2,6 Hz); 6,77 ppm (1H, d, Ph-H³); 7,12-7,28 ppm (5H, m, Ph'-H); 8,38 ppm (1H, d, Ph-H⁶).

### Beispiel 11

### Herstellung von 2-Benzyl-2-dimethylamino-1-[2-(2-trimethoxysilyl-propyl)--4-morpholino-phenyl]-1-butanon (11)

5,49 g (15 mmol) 2-Benzyl-2-dimethylamino-1-(4-morpholino-phenyl)-1-butanon, 275 mg (0,3 mmol) RuH₂(CO)(PPh₃)₃ und 5 g (30 mmol) Allyltrimethoxysilan wurden in 20 ml Toluol gelöst und mit Argon entgast. Nach 5 Stunden Erhitzen unter Rühren am Rückfluß wurde das Gemisch über Nacht stehengelassen, nochmals 9 Stunden am Rückfluß gerührt und wiederum bei Raumtemperatur stehengelassen. Es wurden 280 mg (0,3 mmol) RuH₂(CO)(PPh₃)₃ zugegeben und das Gemisch 9 Stunden gekocht; dann wurden nochmals nach Stehen über Nacht 260 mg (0,3 mmol) RuH₂(CO)(PPh₃)₃ zugesetzt und das Ganze erneut 9 Stunden gekocht. Nach Abdestillieren des Lösemittels wurde chromatographiert (Kieselgel, Heptan/CH₂Cl₂/Ethylacetat) und schließlich mittels Gelpermeationschromatographie (Sephadex LH-20, Methanol) eine reine Fraktion von 0,33 g (4%) **(11)** als gelbes Öl erhalten, ¹H-NMR (CDCl₃): 0,68 ppm (3H, t, Bu-H⁴, ³J_{H,H}=7,2 Hz); 0,77 ppm (mc, 2H, Prop-H³); 1,64-1,96 ppm (4H, m, Bu-H³ und Prop-H²); 2,38 ppm (6H, s, N(CH₃)₂); 2,64 ppm (2H, mc, Prop-H¹); 3,16 ppm (2H, mc, CH₂-Ph); 3,24 ppm (4H, mc, Morpholin-N-CH₂); 3,57 ppm (9H, s, Si(OCH₃)₃); 3,85 ppm (4H, mc, Morpholin-O-CH₂); 6,61 ppm (1H, dd, Ph-H⁵, ³J_{H⁵,H⁶}=8,6 Hz); 6,72 ppm (1H, d, Ph-H³, ⁴J_{H³,H⁵}=2,4 Hz); 7,13-7,25 ppm (5H, m, Ph'-H); 8,38 ppm (1H, d, Ph-H⁶).

### Beispiel 12

### Herstellung von 1-(2-Trimethoxysilyl-ethyl-thioxanthon (12) und 1,8-Bis-(2-trimethoxysilyl-ethyl)-thioxanthon (13)

4,24 g (20 mmol) Thioxanthon, 360 mg (0,4 mmol) RuH₂(CO)(PPh₃)₃ und 2,36 ml (22 mmol) Vinyltrimethoxysilan wurden in 30 ml Toluol 6 Stunden am Rückfluß gekocht. Nach Zugabe von weiteren 230 mg (0,25 mmol) RuH₂(CO)(PPh₃)₃ wurde die Reaktionslösung abkühlen gelassen und von dem ausgefallenen Thioxanthon abgetrennt. Das Produktgemisch wurde nach Einengen der Lösung chromatographiert (Kieselgel, CH₂Cl₂/Ethylacetat-Gemische). Es wurden 2 Fraktionen erhalten:
1,3 g (18 %) **12** (gelbes Öl), das durch Kugelrohrdestillation weiter gereinigt werden konnte ¹H-NMR (CDCl₃): 1,13 ppm (2H, mc, Et-H²); 3,37 ppm (2H, mc, Et-H¹); 3,65 ppm (9H, s, Si(OCH₃)₃); 7,28 ppm (1H, mc) + 7,39-7,46 ppm (3H, m) + 7,48-7,52 ppm (1H, m) + 7,55 ppm (1H, mc) = H²⁻⁷ sowie 8,46 ppm (1H, mc, H⁸), sowie
1,77 g (17 %) **13**, das nach Kugelrohrdestillation eine kristalline, gelbe Masse ergab ¹H-NMR (CDCl₃): 1,17 ppm (4H, mc, Et-H²); 3,17 ppm (4H, mc, Et-H¹); 3,62 ppm (18H, s, Si(OCH₃)₃); 7,27 ppm (2H, mc) + 7,32-7,43 ppm (4H, m) = H²⁻⁷).

### Beispiel 13

### Herstellung von 2-lsopropyl-8-(2-trimethoxysilyl-ethyl)-thioxanthon (14) und 2-Isopropyl-1,8-bis-(2-trimethoxysilyl-ethyl)-thioxanthon (15)

10,17 g (40 mmol) 2-Isopropylthioxanthon, 735 mg (0,8 mmol) RuH₂(CO)(PPh₃)₃ und 6,72 ml (44 mmol) Vinyltrimethoxysilan wurden in 50 ml Toluol durch Einleiten von N₂ entgast. Nach 24 Stunden Kochen am Rückfluß wurde eingeengt und chromatographiert (Kieselgel, CH₂Cl₂/Ethylacetat-Gemische). Es wurden 2 Fraktionen erhalten:
9,8 g (61 %) **14** als gelbes Öl ¹H-NMR (CDCl₃): 1,15 ppm (2H, mc, Et-H²); 1,32 ppm (6H, d, Isopropyl-CH₃, ³J_{H,H}=6,6 Hz); 3,04 ppm (1H, hept., Isopropyl-H²); 3,38 ppm (2H, mc, Et-H¹); 3,65 ppm (9H, s, Si(OCH₃)₃); 7,27 ppm (1H, mc) + 7,40-7,49 ppm (4H, m) = H³⁻⁷; 8,34 ppm (1H, s(br.), H¹) sowie
1,37 g (6 %) 15 als gelbes Öl (¹H-NMR (CDCl₃): 1,16 + 1,18 ppm (4H, jeweils mc, Et-H²); 1,32 ppm (6H, d, Isopropyl-CH₃, ³J_{H,H}=6,6 Hz); 3,10 + 3,16 ppm (4H, mc, Et-H¹); 3,40 ppm (1H, hept., Isopropyl-H²); 3,61 ppm (181-1, s, Si(OCH₃)₃); 7,25 - 7,44 ppm (5H, m, _{H}³⁻⁷).

### Beispiel 14

### Herstellung von 2-Benzyl-2-dimethylamino-1-[2-(2-(methyl-bis(trimethylsilyloxy)silyl)-silyloxy)silyl)-ethyl)-4-morpholino-phenyl]-1-butanon (16)

8,1 g (22 mmol) 2-Benzyl-2-dimethylamino-1-(4-morpholino-phenyl)-1-butanon, 370 mg (0,4 mmol) RuH₂(CO)(PPh₃)₃ und 5,0 g (20 mmol) Vinylmethylbis(trimethylsilyloxy)silan wurden in 30 ml Toluol gelöst und mit N₂ entgast. Nach 48 Stunden Erhitzen unter Rühren am Rückfluß wurde das Lösemittel abdestilliert und der Rückstand chromatographiert (Kieselgel, Heptan/Ethylacetat). Es wurden 4,9 g (40 %) eines zähen, leicht rötlichen Öls erhalten. ¹H-NMR (CDCl₃): 0,09 ppm (3H, s, Si-CH₃); 0,11 ppm (18H, s, Si(CH₃)₃); 0,65 ppm (3H, t, Bu-H⁴); 0,89 ppm (2H, mc, Et-H²); 1,87 ppm (2H, mc, Bu-H³); 2,35 ppm (6H, s, N(CH₃)₂); 2,65 ppm (2H, mc, Et-H¹); 3,16 ppm (2H, mc, CH₂-Ph'); 3,24 ppm (4H, mc, Morpholin-N-CH₂); 3,85 ppm (4H, mc, Morpholin-O-CH₂); 6,59 ppm (1H, dd, Ph-H⁵, ³J_{H⁵,H⁶}=8,4 Hz); 6,73 ppm (1H, d, Ph-H³, ⁴J_{H³,H⁵}=2,6 Hz); 7,12-7,28 ppm (5H, m, Ph'-H); 8,35 ppm (1H, d, Ph-H⁶).

### Beispiel 15

### Reaktion eines Dimethylsiloxan-Vinylmethylsiloxan-Copolymeren mit 2-Benzyl-2-dimethylamino-1-(4-morpholinophenyl)-1-butanon zu (17)

13,7 g (37,4 mmol) 2-Benzyl-2-dimethylamino-1 -(4-morpholinophenyl)-1-butanon, 0,69 g (0,75 mmol) RuH₂(CO)(PPh₃)₃ und 25 g eines Dimethylsiloxan-Vinylmethylsiloxan-Copolymeren (7,5 % Vinylmethyleinheiten, η = 1000 mm²/s) wurden in 30 ml Toluol gelöst, mit Stickstoff entgast und unter Rühren 100 Stunden am Rückfluß erwärmt. Nach Einengen, Aufnehmen in Heptan, Aufgeben auf Kieselgel und Eluieren mit ca. 500 ml Heptan wurden 24,8 g eines leicht rötlichen Öls isoliert, dessen ¹H-NMR-Spektrum dem eines kammartig substituierten Polydimethylsiloxans entspricht. Dem Spektrum zufolge waren 68 % der ursprünglich vorhandenen Vinylreste durch 2-[2-(2-Benzyl-2-dimethylamino-butanoyl)-5-morpholino-phenyl]-ethyl-Reste ersetzt. Durch Aufkochen mit Aktivkohle ist eine weitere Reinigung möglich.

### Beispiel 16

### Reaktion eines Polydimethylsiloxans mit endständigen Vinyldimethylsilylgruppen mit 2-Benzyl-2-dimethylamino-1-(4-morpholinophenyl)-1-butanon zu (18)

16,1 g (44 mmol) 2-Benzyl-2-dimethylamino-1-(4-morpholinophenyl)-1-butanon, 367 mg (0,4 mmol) RuH₂(CO)(PPh₃)₃ und 9,1 g eines Polydimethylsiloxans mit endständigen Vinyldimethylsilylgruppen (η= 4-6 mm²/s) wurden in 50 ml Toluol gelöst und mit Stickstoff entgast. Nach 52 Stunden Erhitzen unter Rühren am Rückfluß wurde chromatographisch aufgearbeitet. Es wurden 9,3 g eines rötlichen Öls **(18)** isoliert, dessen ¹H-NMR-Spektrum dem eines endständig substituierten Polydimethylsiloxans entsprach, das praktisch keine Vinyl-Endgruppen mehr zeigte und statt dessen die für die 2-[2-(2-Benzyl-2-dimethylamino-butanoyl)-5-morpholino-phenyl]-ethyl- Reste) typischen Signale aufwies (vgl. Verbindungen **9** und **10**).

### Beispiel 17

### Verwendung der durch Trialkoxysilylalkyl-Reste substituierten Photoinitiatoren zur Kondensationshärtung von Silikonen

Es wurde eine Stammlösung aus 20,0 g Toluol, 5 g einer 33 %igen Lösung eines Si-OH-Gruppen enthaltenden Polydimethylsiloxans in Toluol und 0,1 g eines metallorganischen Vernetzungskatalysators auf Basis Zinn hergestellt. Jeweils 2,5 g dieser Stammlösung wurden mit 75 (± 5) mg der in Tabelle 4 angegebenen erfindungsgemäßen Verbindung versetzt, mit einem Zugstab auf eine Polyesterfolie aufgerakelt und bei 105°C 2 Minuten lang im Umluftofen gehärtet. Die Eigenschaften der dabei erhaltenen Silikonkautschuke sind zusammen mit den optischen Eigenschaften der dargestellten substituierten Photoinitiatoren in der folgenden Tabelle zusammengefaßt. Verwendet man geringere Konzentrationen an erfindungsgemäßen Photoinitiator als in den Beispielen, werden klare Silikonschichten erhalten.

**Tabelle 4:**

| Optische Spektren der verschiedenen Photoinitiatorderivate und Eigenschaften bezüglich der Kondensationsvernetzung von Silikonen | | | |
|---|---|---|---|
| Verb. Nr. | Kondensationsvernetzung | Eigenschaften des vernetzten Silikons | optische Eigenschalten ^{b)} |
| **1** | ja | trüb, milchig, abriebfest | 329 (Schulter) |
| **2** | ja | trüb, leicht milchig, fast abriebfest | 325 (Schulter) |
| **3** | ja | trüb, farblos, nicht ganz abriebfest | 325 (Schulter) |
| **4** | teilw. | klar, farblos, leicht schmierig, Härtung unvollständig^{c)} | 325 (Schulter) |
| **5** | ja | klar, farblos, abriebfest | 328 (Schulter) |
| **6** | ja | trüb, leicht milchig, nicht ganz abriebfest | 271 (Schulter) |
| **7** | n.b. ^{a)} | | 295 (12400) |
| **8** | n.b. | | |
| **9** | ja | trüb, milchig, fast abriebfest | 312 (15400) |
| **10** | ja | klar, gelblich, abriebfest^{d)} | 311 (15800) |
| **11** | n.b. | | |
| **12** | ja | trüb, milchig, abriebfest | 380 (5760) 259 (35900) |
| **13** | ja | trüb, milchig, abriebfest | 375 (4660) 260 (35600) |
| **14** | n.b. | | 385 (6180) 261 (41200) |
| **15** | n.b. | | 376 (5400) 260 (37800) |

| | | | |
|---|---|---|---|
| ^{a)} nicht bestimmt | | | |
| ^{b)} λₘₐₓ [nm]; ε [l•mol⁻¹cm⁻¹] der erfindungsgemäßen Verbindungen in CH₂Cl₂ | | | |
| ^{c)} unvollständig ausgehärtet, Trockenzeit zu kurz | | | |
| ^{d)} Vernetzung mit einem geringeren Anteil Trialkoxysilan-Derivat | | | |

### Beispiel 18

### Kovalente Fixierung von Trialkoxysilylalkyl-substituierten Photoinitiatoren bei der Kondensationshärtung von Silikonen

a) Eine Lösung aus 13,5 g Toluol, 4,5 g der in Beispiel 17 angegebenen Polydimethylsiloxanlösung in Toluol, 0,1 g einer 50 %igen Lösung von 2-Benzyl-2-dimethylamino-1-[2-(2-triethoxysilyl-ethyl)-4-morpholino-phenyl]-1-butanon **(10)** und 0,12 g des in Beispiel 17 angegebenen Vernetzungskatalysators wurde in eine Glasschale gegossen und 5 Minuten bei 120°C gehärtet. Der erhaltene klare Silikonkautschuk wurde mit Dichlormethan 3 Stunden extrahiert. Im Extrakt fanden sich nach UV/Vis-spektroskopischer Bestimmung 34 % des eingesetzten Photoinitiators.
b) Der unter a) beschriebene Versuch wurde wiederholt, jedoch statt **10** wurde 2-Benzyl-2-dimethylamino-1-(2-(2-trimethoxysilyl-ethyl)-4-morpholino-phenyl)-1-butanon **(9)** verwendet. Der erhaltene klare Silikonkautschuk wurde mit Dichlormethan 3 Stunden extrahiert. Im Extrakt fanden sich nach UV/Vis-spektroskopischer Bestimmung 2 % des eingesetzten Photoinitiators.

### Beispiel 19

### Verwendung von 2-Benzyl-2-dimethylamino-1-[2-(2-triethoxysilyl-ethyl)-4-morpholino-phenyl]-1-butanon (10) als Photoinitiator in einem Photopolymergemisch

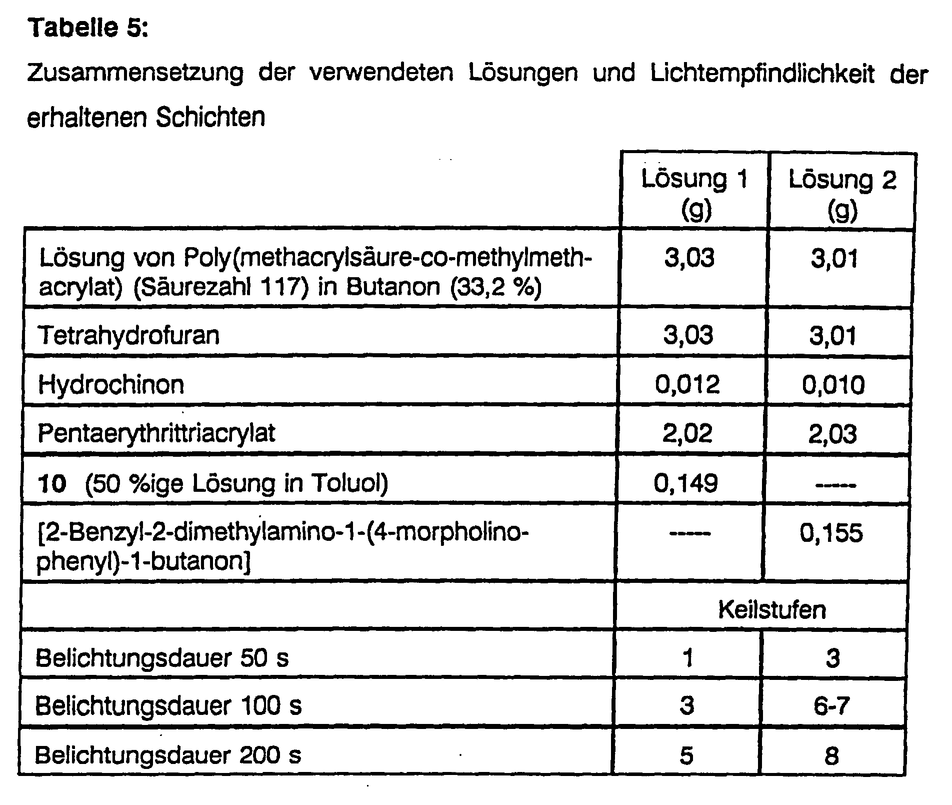

Eine Aluminiumplatte wurde mit einer Rakel mit den Lösungen 1 und 2 beschichtet, die Schicht jeweils 2 Minuten bei 100°C getrocknet, eine biaxial verstreckte und thermofixierte Polyesterfolie (23 µm) bei 100°C Walzentemperatur auf die Schicht laminiert und diese unter einem Standard-Stufenkeil (Ugra-Keil) mit einer Quecksilber-Hochdrucklampe unter Variation der Belichtungszeit belichtet (siehe Tabelle 5). Die Entwicklung erfolgte nach Abziehen der Folie durch Abreiben mit Essigsäureethylester. In Tabelle 5 ist die jeweils erste vollständig gehärtete Keilstufe angegeben.

### Beispiel 20

### Verwendung von 2-Benzyl-2-dimethylamino-1-[2-(2-triethoxysllyl-ethyl)-4-morpholino-phenyl]-1-butanon (10) zur Herstellung einer Druckplatte

Eine Lösung aus 6,0 g der in Beispiel 19 angegebenen Methacrylsäurecopolymerisatlösung, 8,0 g Tetrahydrofuran, 1,6 g Pentaerythrittriacrylat und 0,1 g Hydrochinon wurde mit einer Rakel auf eine Aluminiumplatte aufgebracht und die Schicht bei 105°C im Umluftofen 2 Minuten getrocknet. Eine Lösung aus 13,56 g Toluol, 4,27 g der in Beispiel 17 angegebenen Polydimethylsiloxanlösung, 0,88 g eines Silikons mit seitenständigen Acrylsäuregruppen, 0,09 g Hydrochinonmonomethylether, 0,16 g des in Beispiel 17 angegebenen Vernetzungskatalysators, 0,12 g Renolblau B2G (C. I. 74160), und 1,12 g einer 33 %igen Lösung von **10** in Toluol wurde mit einer Rakel auf eine 10 µm dicke Polyethylenfolie aufgebracht und im Umluftofen bei 105°C 3 Minuten gehärtet. Die so beschichtete Folie wurde bei 100°C auf den mit der Photopolymerlösung beschichteten Aluminiumträger laminiert. Nach dem Belichten mit einer Quecksilber-Hochdrucklampe wurde die Folie abgezogen. In den belichteten Bereichen haftete das Silikon an der Photopolymerschicht, während es in den unbelichteten Bereichen mit der Folie von der Photopolymerschicht getrennt wurde. Dementsprechend waren die belichteten Bereiche farbabstoßend, während die unbelichteten Bereiche Druckfarbe annahmen.

## Patentansprüche

1. Verbindungen der allgemeinen Formel I
(SIL - X-)ₘIN (I),
worin
SIL einen Rest der Formel Si(R¹)(R²)(R³)
wobei
R¹ ein Alkyl-, Halogenalkyl- oder Alkoxyrest mit 1 bis 8 Kohlenstoffatomen, ein Alkenylrest, ein Alkenyloxyoder Acyloxyrest mit 2 bis 8 Kohlenstoffatomen, ein Aryl- oder Aryloxyrest mit 6 bis 10 Kohlenstoffatomen, ein Dialkyl-, Diaryl- oder Alkylaryl-methylenaminooxyrest mit C₁-C₄-Alkyl- oder C₆-Arylgruppen ist und
R² und R³ gleiche oder verschiedene Reste der Bedeutung von R¹ oder X - IN sind
X CₙH₂ₙ,
IN der Rest einer als Photoinitiator bzw. Photosensibilisator wirksamen Verbindung mit mindestens einer an einem aromatischen Kern stehenden Carbonylgruppe,
m eine Zahl von 1 bis 4 und
n eine Zahl von 2 bis 12 bedeutet,
oder Verbindungen der allgemeinen Formel II
SiₒOₒ₋₁ (-X-IN)ₚR⁴ ₂ₒ₊₂₋ₚ (II)
worin
R⁴ ein Rest der Bedeutung von R¹ ist und mehrere R⁴ untereinander gleich oder verschieden sein können,
o eine Zahl von 2 bis 20000 und
p eine Zahl von 1 bis o ist,
und die Symbole X und IN die vorstehend angegebene Bedeutung haben,
wobei die Gruppe X an ein zur Carbonylgruppe von IN orthoständiges aromatisches Kohlenstoffatom gebunden ist.

2. Verbindungen gemäß Anspruch 1, **dadurch gekennzeichnet, daß**
IN ein Rest einer der Formeln V und VI 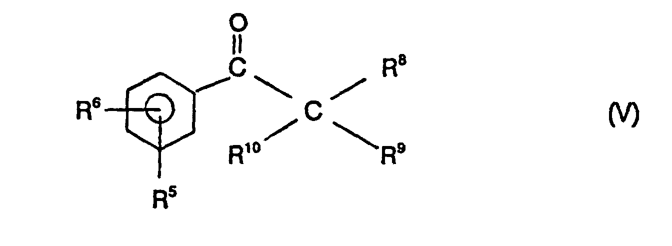 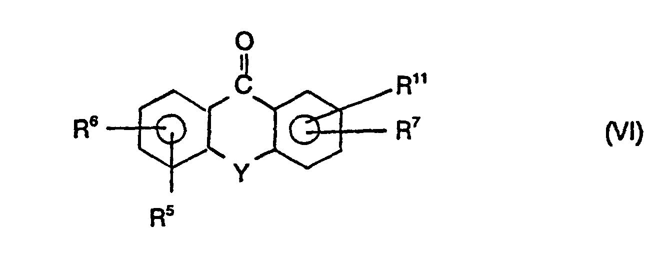 ist,
worin
R⁵, R⁶ u. R⁷ gleich oder verschieden sind und Wasserstoff-, Halogenatome, Phenyl-, Benzyl-, Benzoylreste, Alkylreste mit 1 bis 12 Kohlenstoffatomen, Cycloalkylreste mit 5 bis 6 Kohlenstoffatomen oder Reste der Formeln OR¹², SR¹², SOR¹⁵, SO₂R¹⁵, N(R¹³)(R¹⁴), NH-SO₂-R¹⁵ oder NHCOR¹⁵ bedeuten,
R⁸ und R⁹ gleich oder verschieden sind und Wasserstoffatome, Alkylreste mit 1 bis 12 Kohlenstoffatomen, Alkenylreste mit 2 bis 12 Kohlenstoffatomen, 5- oder 6-gliedrige Cycloalkylreste, Aralkylreste mit 7 bis 9 Kohlenstoffatomen, OR¹², CH₂OR¹² oder N(R¹³)(R¹⁴) bedeuten oder gemeinsam mit dem Kohlenstoffatom, an das sie gebunden sind, einen cycloaliphatischen Ring mit 5 bis 6 Gliedern bilden,
R¹⁰ ein Wasserstoffatom, OR¹² oder einen Arylrest mit 6 bis 8 Kohlenstoffatomen bedeutet,
wobei
R⁸, R⁹ und R¹⁰ gemeinsam mit dem Kohlenstoffatom, an das sie gebunden sind, einen ggf. substituierten Benzolring bedeuten können und wobei diese Reste einzeln nicht gleichzeitig Wasserstoffatome oder Methylgruppen bedeuten,
R¹¹ X - SIL oder R⁷ bedeutet und im Falle X - SIL in der 1-Stellung des Dreiringsystems der Formel VI steht,
R¹² ein Wasserstoffatom, einen Alkylrest mit 1 bis 12 Kohlenstoffatomen, einen 5- oder 6-gliedrigen Cycloalkylrest oder einen Alkanoylrest mit 2 bis 13 Kohlenstoffatomen bedeutet,
R¹³ und R¹⁴ gleich oder verschieden sind und Wasserstoffatome, Alkylreste mit 1 bis 12 Kohlenstoffatomen oder 5- oder 6-gliedrige Cycloalkylreste bedeuten oder gemeinsam mit dem Stickstoffatom, an das sie gebunden sind, einen 5- oder 6-gliedrigen heterocyclischen Ring bilden, der als weiteres Heteroatom O, S oder N enthalten kann,
R¹⁵ einen Alkylrest mit 1 bis 12 Kohlenstoffatomen oder einen Arylrest mit 6 bis 10 Kohlenstoffatomen und
Y O, S, NR¹², CH₂, C(O) oder eine Einfachbindung bedeutet, wobei im Falle Y = C(O) auch in der 4- und 5-Stellung des Dreiringsystems Reste X - SIL stehen können.

3. Verfahren zur Herstellung von Verbindungen der allgemeinen Formeln I oder II gemäß Anspruch 1, **dadurch gekennzeichnet, daß** man eine Verbindung der Formel III
IN - H, (III)
in der das Wasserstoffatom an einem aromatischen Kohlenstoffatom in einer ortho-Position zu einer Carbonylgruppe steht, in Gegenwart einer katalytischen Menge einer Rutheniumverbindung mit einer Verbindung der Formel IV
SIL - X' (IV)
oder einer Verbindung der Formel IVA
SiₒOₒ₋₁ (-X')ₚR⁴ ₂ₒ₊₂₋ₚ (IVA)
umsetzt, wobei X' ein ω-Alkenylrest mit 2 bis 12 Kohlenstoffatomen ist und IN, SIL, R⁴, o und p die in Anspruch 1 angegebene Bedeutung haben.

4. Verfahren nach Anspruch 3, **dadurch gekennzeichnet, daß** die Umsetzung bei erhöhter Temperatur durchgeführt wird.

5. Verfahren nach Anspruch 3, **dadurch gekennzeichnet, daß** die Umsetzung in einem organischen Lösemittel durchgeführt wird.

6. Lichtempfindliches Gemisch, enthaltend
a) ein Polysiloxan
b) eine radikalisch polymerisierbare Verbindung mit mindestens einer endständigen ethylenisch ungesättigten Gruppe und
c) eine bei Bestrahlung mit aktinischem Licht Radikale bildende Verbindung,
**dadurch gekennzeichnet, daß** die Radikale bildende Verbindung (c) eine Verbindung gemäß einem der Ansprüche 1 und 2 ist.

## Claims

1. A compound of the formula I
(SIL-X-)ₘIN (I),
in which
SIL is a radical of the formula Si(R¹) (R²) (R³), where
R¹ is an alkyl, haloalkyl or alkoxy radical of 1 to 8 carbon atoms, an alkenyl radical, an alkenyloxy or acyloxy radical of 2 to 8 carbon atoms, an aryl or aryloxy radical of 6 to 10 carbon atoms, or a dialkyl-, diaryl- or alkylaryl-methyleneaminooxy radical having C₁-C₄-alkyl or C₆-aryl groups, and
R² and R³ are identical or different radicals with the meaning of R¹ or X-IN,
X is a group CₙH₂ₙ,
IN is the radical of a compound which is active as a photoinitiator or photosensitizer and which has at least one carbonyl group located on an aromatic nucleus,
m is a number from 1 to 4, and
n is a number from 2 to 12,
or compounds of the formula II
SiₒOₒ₋₁ (-X-IN)ₚR⁴ ₂ₒ₊₂₋ₚ (II)
in which
R⁴ is a radical with the meaning of R¹, and two or more radicals R⁴ may be the same as or different from one another,
o is a number from 2 to 20,000, and
p is a number from 1 to o,
and the symbols X and IN are as defined above, the group X being attached to an aromatic carbon atom which is positioned ortho to the carbonyl group of IN.

2. A compound as claimed in claim 1, wherein
IN is a radical of one of the formulae V and VI 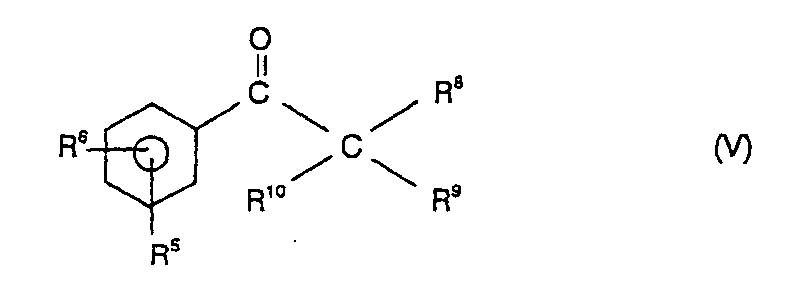 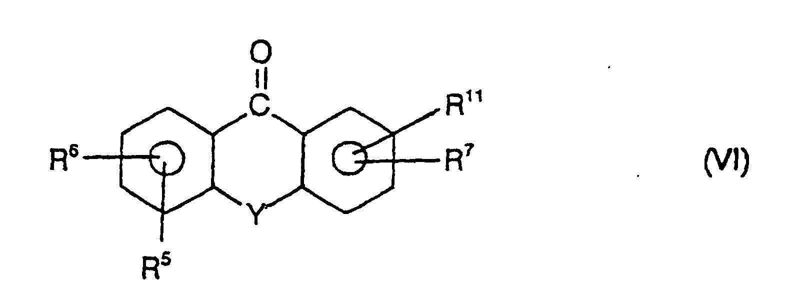 in which
R⁵, R⁶ and R⁷ are identical or different and are hydrogen atoms, halogen atoms, phenyl, benzyl or benzoyl radicals, alkyl radicals of 1 to 12 carbon atoms, cycloalkyl radicals of 5 to 6 carbon atoms or radicals of the formulae OR¹², SR¹², SOR¹⁵, SO₂R¹⁵, N(R¹³)(R¹⁴), NH-SO₂-R¹⁵ or NHCOR¹⁵,
R⁸ and R⁹ are identical or different and are hydrogen atoms, alkyl radicals of 1 to 12 carbon atoms, alkenyl radicals of 2 to 12 carbon atoms, 5- or 6-membered cycloalkyl radicals, aralkyl radicals of 7 to 9 carbon atoms, OR¹², CH₂OR¹² or N(R¹³) (R¹⁴), or together with the carbon atom to which they are attached form a cycloaliphatic ring of 5 to 6 members,
R¹⁰ is a hydrogen atom, OR¹² or an aryl radical of 6 to 8 carbon atoms,
where
R⁸, R⁹ and R¹⁰ together with the carbon atom to which they are attached may be a substituted or unsubstituted benzene ring, and where these radicals individually may not simultaneously be hydrogen atoms or methyl groups,
R¹¹ is X-SIL or R⁷, and if the former is true is in position 1 of the triple-ring system of the formula VI,
R¹² is a hydrogen atom, an alkyl radical of 1 to 12 carbon atoms, a 5- or 6-membered cycloalkyl radical or an alkanoyl radical of 2 to 13 carbon atoms,
R¹³ and R¹⁴ are identical or different and are hydrogen atoms, alkyl radicals of 1 to 12 carbon atoms or 5- or 6-membered cycloalkyl radicals, or together with the nitrogen atom to which they are attached form a 5- or 6-membered heterocyclic ring which may contain O, S or N as additional heteroatom,
R¹⁵ is an alkyl radical of 1 to 12 carbon atoms or an aryl radical of 6 to 10 carbon atoms, and
Y is O, S, NR¹², CH₂, C(O) or a single bond, and if Y = C(O) radicals X-SIL may also be present in positions 4 and 5 of the triple-ring system.

3. A process for the preparation of a compound of the formula I or II as claimed in claim 1, which comprises reacting a compound of the formula III
IN-H (III)
in which the hydrogen atom is on an aromatic carbon atom positioned ortho to a carbonyl group, in the presence of a catalytic amount of a ruthenium compound, with a compound of the formula IV
SIL-X' (IV)
or a compound of the formula IVA
SiₒOₒ₋₁ (-X')ₚR⁴ ₂ₒ₊₂₊ₚ (IVA)
in which X' is an ω-alkenyl radical of 2 to 12 carbon atoms and IN, SIL, R⁴, o and p are as defined in claim 1.

4. The process as claimed in claim 3, wherein the reaction is carried out at elevated temperature.

5. The process as claimed in claim 3, wherein the reaction is carried out in an organic solvent.

6. A photosensitive mixture comprising
a) a polysiloxane,
b) a free-radically polymerizable compound having at least one terminal ethylenically unsaturated group, and
c) a compound which forms radicals when irradiated with actinic light,
wherein the radical-forming compound (c) is a compound as claimed in either of claims 1 and 2.

## Revendications

1. Composés répondant à la formule I
(SIL-X-)ₘIN (I),
dans laquelle
SIL représente un radical répondant à la formule Si(R¹) (R²) (R³),
dans laquelle
R¹ représente un radical alkyle, haloalkyle ou alcoxy en C₁-C₈, un radical alcényle, un radical alcényloxy ou acyloxy en C₂-C₈, un radical aryle ou aryloxy en C₆-C₁₀, ou un radical dialkyle, diaryle ou alkylaryle-méthylèneaminooxy possédant des groupes alkyle en C₁-C₄ ou aryle en C₆, et
R² et R³ représentent des radicaux identiques ou différents avec la signification de R¹ ou X-IN,
X est un groupe CₙH₂ₙ,
IN est le radical d'un composé agissant comme photoamorceur ou photosensibilisateur et possédant au moins un groupe carbonyle situé sur un noyau aromatique,
m est un nombre de 1 à 4, et
n est un nombre de 2 à 12,
ou composés répondant à la formule II
SiₒOₒ₋₁(-X-IN)ₚR⁴ ₂ₒ₊₂ₚ (II)
dans laquelle
R⁴ représente un radical avec la signification de R¹, plusieurs radicaux R⁴ pouvant être identiques ou différents,
o est un nombre de 2 à 20 000, et
p est un nombre de 1 à o,
et les symboles X et IN ont la signification susmentionnée,
le groupe X étant lié à un atome de carbone aromatique en position ortho par rapport au groupe carbonyle de IN.

2. Composés selon la revendication 1, **caractérisés en ce que**
IN est un radical répondant à l'une quelconque des formules V et VI 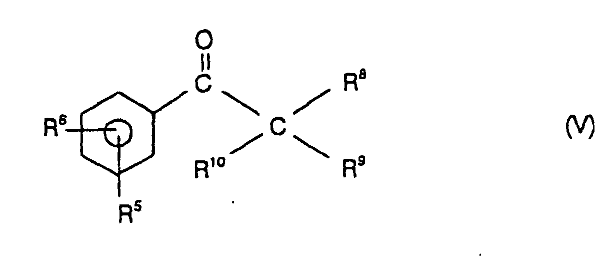 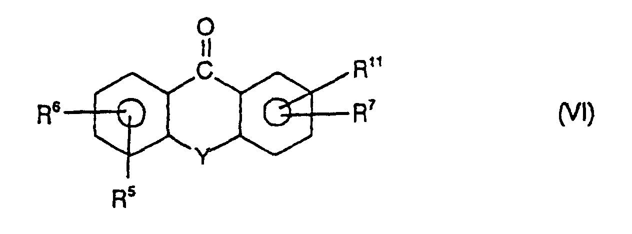 dans lesquelles
R⁵, R⁶ et R⁷ sont identiques ou différents et représentent des atomes d'hydrogène, des atomes d'halogène, des radicaux phényle, benzyle ou benzoyle, des radicaux alkyle en C₁-C₁₂, des radicaux cycloalkyle en C₅-C₆ ou des radicaux répondant à la formule OR¹², SR¹², SOR¹⁵, SO₂R¹⁵, N(R¹³)(R¹⁴), NH-SO₂-R¹⁵ ou NHCOR¹⁵,
R⁸ et R⁹ sont identiques ou différents et représentent des atomes d'hydrogène, des radicaux alkyle en C₁-C₁₂, des radicaux alcényle en C₂-C₁₂, des radicaux cycloalkyle pentagonaux ou hexagonaux, des radicaux aralkyle en C₇-C₉, OR¹², CH₂OR¹² ou N(R¹³)(R¹⁴), ou R⁸ et R⁹ conjointement avec l'atome de carbone auquel ils sont liés constituent un noyau cycloaliphatique en C₅-C₆ ; et
R¹⁰ représente un atome d'hydrogène, OR¹² ou un radical aryle en C₆-C₈,
R⁸, R⁹ et R¹⁰ conjointement avec l'atome de carbone auquel ils sont liés constituant un noyau benzénique substitué ou non, et lesdits radicaux représentant chacun indépendamment l'un de l'autre non simultanément des atomes d'hydrogène ou des groupes methyle,
R¹¹ représente X-SIL en position 1 du système tricyclique répondant à la formule VI, ou est R⁷,
R¹² représente un atome d'hydrogène, un radical alkyle en C₁-C₁₂, un radical cycloalkyle pentagonal ou hexagonal ou un radical alcanoyle en C₂-C₁₃,
R¹³ et R¹⁴ sont identiques ou différents et représentent des atomes d'hydrogène, des radicaux alkyle en C₁-C₁₂ ou des radicaux cycloalkyle pentagonaux ou hexagonaux, ou R¹³ et R¹⁴ conjointement avec l'atome d'azote auquel ils sont liés constituent un noyau hétérocyclique pentagonal ou hexagonal pouvant renfermer O, S ou N comme hétéroatomes supplémentaires,
R¹⁵ est un radical alkyle en C₁-C₁₂ ou un radical aryle en C₆-C₁₀, et
Y représente O, S, NR¹², CH₂, C(O) ou une liaison simple, et si Y = C(O) des radicaux X-SIL peuvent être situés également en position 4 et 5 du système tricyclique.

3. Procédé de préparation pour composés répondant à la formule I ou II selon la revendication 1, **caractérisé en ce qu'**on fait réagir un composé répondant à la formule III
IN-H (III)
dans laquelle l'atome d'hydrogène est situé sur un atome de carbone aromatique en position ortho par rapport à un groupe carbonyle, en présence d'une quantité catalytique d'un composé au ruthénium,
avec un composé répondant à la formule IV
SIL-X' (IV)
ou un composé répondant à la formule IVA
SiₒOₒ₋₁(-X')ₚR⁴ ₂ₒ₊₂ₚ (IVA)
dans laquelle X' représente un radical ω-alcényle en C₂-C₁₂ et IN, SIL, R⁴, o et p ont les significations conformes à la revendication 1.

4. Procédé selon la revendication 3, **caractérisé en ce que** la réaction est effectuée à une température élevée.

5. Procédé selon la revendication 3, **caractérisé en ce que** la réaction est effectuée dans un solvant organique.

6. Mélange photosensible comprenant
a) un polysiloxane,
b) un composé polymérisable par voie radicalaire possédant au moins un groupe terminal à insaturation éthylénique, et
c) un composé formant des radicaux libres lorsqu'il est exposé à un rayonnement actinique,
**caractérisé en ce que** le composé formant des radicaux libres (c) est un composé conforme à l'une quelconque des revendications 1 à 2.
